Europäisches Patentamt

European Patent Office

Office européen des brevets

(19)

(11) Veröffentlichungsnummer: **0 217 203**
**B1**

(12) **EUROPÄISCHE PATENTSCHRIFT**

(45) Veröffentlichungstag der Patentschrift:
**27.12.90**

(51) Int. Cl.⁵: **H04Q 3/52, H03K 3/356**

(21) Anmeldenummer: **86112655.5**

(22) Anmeldetag: **12.09.86**

(54) **Breitbandsignal-Raumkoppeleinrichtung.**

(30) Priorität: **23.09.85 DE 3533915**

(43) Veröffentlichungstag der Anmeldung:
**08.04.87 Patentblatt 87/15**

(45) Bekanntmachung des Hinweises auf die Patenterteilung:
**27.12.90 Patentblatt 90/52**

(84) Benannte Vertragsstaaten:
**AT BE CH DE FR GB IT LI NL SE**

(56) Entgegenhaltungen:
**DE-A- 2 431 164**

HASLER-MITTEILUNGEN, Band 33, Nr. 1, April 1974, Seiten 20-32, Bern, CH; M. LAMOTH et al.: "Der elektronische Koppelpunkt KP 2x2"
PROCEEDINGS OF THE INTERNATIONAL SWITCHING SYMPOSIUM, 7.-11. Mai 1984, Florence, IT, Teil 2, Seiten 1-6, "Session 31C paper 3"; L. DURET et al.: "Integrated crosspoint technology for wide band space division switching networks"
IEEE JOURNAL OF SOLID-STATE CIRCUITS, Band SC-10, Nr. 2, April 1975, Seiten 117-122, IEEE, New York, US; M. SUNAZAWA et al.: "Low power CML IC crosspoint switch matrix for space division digital switching network"
REVIEW OF THE ELECTRICAL COMMUNICATION

(73) Patentinhaber: **Siemens Aktiengesellschaft,
Wittelsbacherplatz 2, D-8000 München 2(DE)**

(72) Erfinder: **Hofmann, Rüdiger, Dr., Fürstenfelder Weg 12,
D-8031 Gilching(DE)**

(56) Entgegenhaltungen: (Fortsetzung)
LABORATORIES, Band 25, Nr. 1-2, Januar-Februar 1977, Seiten 43-51, Tokyo, JP; M. SUNAZAWA et al.: "Wideband integrated crosspoint switch matrix"

## Beschreibung

Neuere Entwicklungen der Fernmeldetechnik führen zu diensteintegrierenden Nachrichtenübertragungs- u. -vermittlungssystemen für Schmalband- und Breitband-Kommunikationsdienste, die als Übertragungsmedium im Bereich der Teilnhmeranschlußleitungen Lichtwellenleiter vorsehen, über die sowohl die Schmalbandkommunikationsdienste, wie insbesondere 64-kbits/s-Digital-Telefonie, als auch Breitbandkommunikationsdienste, wie insbesondere 140-Mbit/s-Bildtelefonie, geführt werden, wobei aber in den Vermittlungsstellen (vorzugsweise gemeinsame Steuereinrichtungen aufweisende) Schmalbandsignal-Koppeleinrichtungen und Breitbandsignal-Koppeleinrichtungen nebeneinander vorgesehen sind (DE-PS 24 21 002).

Im Zusammenhang mit einer Breitbandsignal-Zeitmultiplex-Koppeleinrichtung, deren Koppelpunkte im Zeitmultiplex jeweils für eine Mehrzahl von Verbindungen genutzt werden, ist es bekannt, jeweils zwei Leitungen mit Hilfe eines Gatterelements zu verbinden, das von einer als bistabiles D-Kippglied gebildeten koppelpunktindividuellen Speicherzelle ein- und ausgeschaltet wird, wobei diese koppelpunktindividuelle Speicherzelle, deren Clock-Eingang ein entsprechendes Taktsignal zugeführt wird, in nur einer Koordinatenrichtung, und zwar an ihrem D-Eingang, angesteuert wird (Pfannschmidt: "Arbeitsgeschwindigkeitsgrenzen von Koppenetzwerken für Breitband-Digitalsignale", Diss., Braunschweig 1978, Bild 6.7). In Anbetracht eines bei einer Bitrate von 140 Mbit/s erreichbaren Zeitmultiplexfaktors von etwa 4 bis 8 und der dabei erforderlichen aufwendigen Schaltungstechnologie werden derzeit allerdings zur Vermittlung von Breitbandsignalen reine Raumkoppeleinrichtungen bevorzugt, in denen die über die einzelnen Koppelpunkte durchgeschalteten Verbindungen allein räumlich voneinander getrennt sind.

Eine reine Breitbandsignal-Raumkoppelanordnung kann als Koppelpunktmatrix ausgebildet sein, in deren Koppelpunkten die Koppelelemente jeweils von einer durch zwei Ansteuerdecoder, nämlich Zeilendecoder und Spaltendecoder, in zwei Koordinaten angesteuerten koppelpunktindividuellen Halte-Speicherzellen gesteuert werden, wobei, um neue Verbindungen einzuschreiben und alte zu löschen, die Halte-Speicherzellen jeweils durch Zeilen- und Spaltendecoder ausgewählt werden (Pfannschmidt, a.a.O., Bild 6.4).

Die Erfindung stellt sich nun die Aufgabe, in einer solchen Breitband-Raumkoppeleinrichtung einen Weg zu einer besonders zweckmäßigen Ansteuerung der entsprechend ausgebildeten Koppelpunkte aufzuzeigen.

Die Erfindung betrifft eine Breitbandsignal-Raumkoppeleinrichtung mit einer Koppelpunktmatrix, deren Koppelelemente jeweils mit Hilfe einer in zwei Koordinaten angesteuerten, mit einem bistabilen D-Kippglied gebildeten koppelpunktindividuellen Speicherzelle gesteuert werden. Diese Breitbandsignal-Raumkoppeleinrichtung ist erfindungsgemäß dadurch gekennzeichnet, daß die Koppelelemente jeweils unmittelbar von den mit bistabilen D-Kippgliedern in C-MOS-Technik gebildeten Speicherzellen gesteuert werden, die von zwei jeweils mit einer Koppelpunktreihen-Adresse und einem Adresstaktsignal beaufschlagten Ansteuerdecodern ansteuerbar sind, von denen der in der einen Koordinatenrichtung (Zeilenrichtung) ansteuernde Decoder mit seinem jeweiligen Decoderausgang an die D-Eingänge der in der betreffenden Matrixreihe angeordneten D-Kippglieder geführt ist und der in der anderen Koordinatenrichtung (Spaltenrichtung) ansteuernde Decoder mit seinem jeweiligen Decoderausgang an die Clock-Eingänge der in der betreffenden Matrixreihe angeordneten D-Kippglieder geführt ist.

Dabei sind die Speicherzellen jeweils mit zwei kreuzgekoppelten C-MOS-Inverterschaltungen gebildet, deren eine mit ihrem Eingang an den zugehörigen Decoderausgang des einen Ansteuerdecoders über ein C-MOS-Transfergate angeschlossen ist, das seinerseits - ebenso wie ein in den zu diesem Eingang der einen C-MOS-Inverterschaltung führenden Rückkopplungsweg eingefügtes weiteres C-MOS-Transfergate - an seinem einen Eingang mit dem Ausgangssignal des zugehörigen Decoderausgangs des anderen Ansteuerdecoders und an seinem anderen Eingang mit dem negierten Ausgangssignal dieses Decoderausgangs beaufschlagt ist; solche dynamisch betriebenen Speicherzellen gewährleisten nicht nur einen sicheren Betrieb der Breitband-Raumkoppeleinrichtung, sondern haben mit nur 10 Transistoren auch nur einen entsprechend geringen Platzbedarf, was bei einer Integration von besonderer Bedeutung ist.

Alternativ dazu können die Speicherzellen jeweils

- mit einem an seinem einen Eingang mit dem Ausgangssignal des zugehörigen Decoderausgangs des einen Ansteuerdecoders und an seinem anderen Eingang (y) mit dem Ausgangssignal des zugehörigen Decoderausgangs des anderen Ansteuerdecoders beaufschlagten C-MOS-NAND-Glied
-- mit einem in Serie zu dessen Parallelschaltung zweier MOS-Transistoren des einen Kanaltyps geschalteten zusätzlichen MOS-Transistor gleichen Kanaltyps
-- und einem parallel zu seiner Serienschaltung zweier MOS-Transistoren des anderen Kanaltyps geschalteten zusätzlichen MOS-Transistor gleichen Kanaltyps
- und einem an seinem einen Eingang mit dem negierten Ausgangssignal des zugehörigen Decoderausgangs des einen Ansteuerdecoders und an seinem anderen Eingang mit dem Ausgangssignal des zugehörigen Decoderausgangs des anderen Ansteuer decoders beaufschlagten C-MOS-NAND-Glied
-- mit einem in Serie zu dessen Parallelschaltung zweier MOS-Transistoren des einen Kanalstyps geschalteten zusätzlichen MOS-Transistor gleichen Kanaltyps
-- und einem parallel zu seiner Serienschaltung zweier MOS-Transistoren des anderen Kanaltyps geschalteten zusätzlichen MOS-Transistor gleichen Kanaltyps

gebildet sein, wobei die Steuerelektroden der beiden zusätzlichen MOS-Transistoren jedes C-MOS-NAND-Gliedes jeweils mit dem Ausgang des jeweils anderen C-MOS-NAND-Gliedes verbunden sind.

Die Erfindung bringt neben dem Vorteil, in einer Koppelpunktmatrix mit bistabilen D-Kippgliedern gebildete koppelpunktindividuelle Halte-Speicherzellen in einfacher Weise jeweils in zwei Koordinaten ansteuern zu können, um eine über den jeweiligen Koppelpunkt verlaufende Verbindung aufzubauen, den weiteren Vorteil mit sich, beim Verbindungsabbau die betreffenden Koppelpunkte jeweils nur in einer der beiden Ansteuerkoordinaten ansteuern zu müssen, um den betreffenden Koppelpunkt wieder auszulösen.

Es sei an dieser Stelle bemerkt, daß aus Hasler-Mitteilungen Vol.33 (1974), Nr.1 (April), 20...32, insbes. S.21 sowie Abb.6 eine Breitbandsignal-Raumkoppeleinrichtung mit einer 2x2-Koppelpunktmatrix bekannt ist, deren Koppelelemente jeweils von einer koppelpunktindividuellen, in Bipolar-Technik gehaltenen Stromquellenschaltung (Biasing Circuit) gesteuert werden, die ihrerseits von einem über Clock- und Dataleitungen in zwei Koordinaten angesteuerten, ebenfalls in Bipolar-Technik gehaltenen Flip-Flops gesteuert werden, wobei zum Setzen des Flip-Flops an die Clock- und Data-Eingänge positive Impulse angelegt werden, während das Rücksetzen des Flip-Flops durch positive Impulse erfolgt, die nur dem Clock-Eingang zugeführt werden.

Solche in Bipolar-Technik gehaltenen, jeweils eine Stromquellenschaltung und ein Flip-Flop umfassenden koppelpunktindividuellen Steuereinheiten sind indessen mit insgesamt 52 Bauelementen (Dioden, Bipolar-Transistoren und Widerständen) sehr aufwendig und haben damit auch einen entsprechend hohen Platzbedarf, was bei einer Integration von 2x2 Koppelpunkten tragbar ist, einer Integration größerer Koppelpunktmatrizen aber Grenzen setzt.

Demgegenüber vermeidet die auf einer direkten Steuerung der Koppelelemente durch koppelpunktindividuelle Halte-Speicherzellen basierende Erfindung den Aufwand für zwischen Halte-Speicherzellen und Koppelelementen vorzusehende Stromquellenschaltungen völlig und bringt außerdem damit, daß die Halte-Speicherzellen mit bistabilen D-Kippgliedern in C-MOS-Technik gebildet sind, eine weitere Verringerung der Anzahl erforderlicher Bauelemente und damit des Platzbedarfs mit sich, was einer Integration auch größerer Koppelpunktmatrizen entsprechend förderlich ist.

Es sei weiter bemerkt, daß (aus Rev. ECL 25(1977)1-2, 43...51) die Verwendung von MOS-Schaltungen in Raumkoppeleinrichtungen bekannt ist, die indessen anders aufgebaut sind und daher keine näheren Berührungspunkte mit der vorliegenden Erfindung haben.

Weitere Besonderheiten der Erfindung werden aus der nachfolgenden näheren Erläuterung der Erfindung anhand der Zeichnung ersichtlich.

Dabei zeigt

FIG 1 das Schema einer Breitband-Koppeleinrichtung gemäß der Erfindung;

FIG 2 zeigt Einzelheiten der schaltungstechnischen Realisierung, und

FIG 3 verdeutlicht zugehörige Signalzustände.

FIG 4 zeigt Einzelheiten einer alternativen Realisierung.

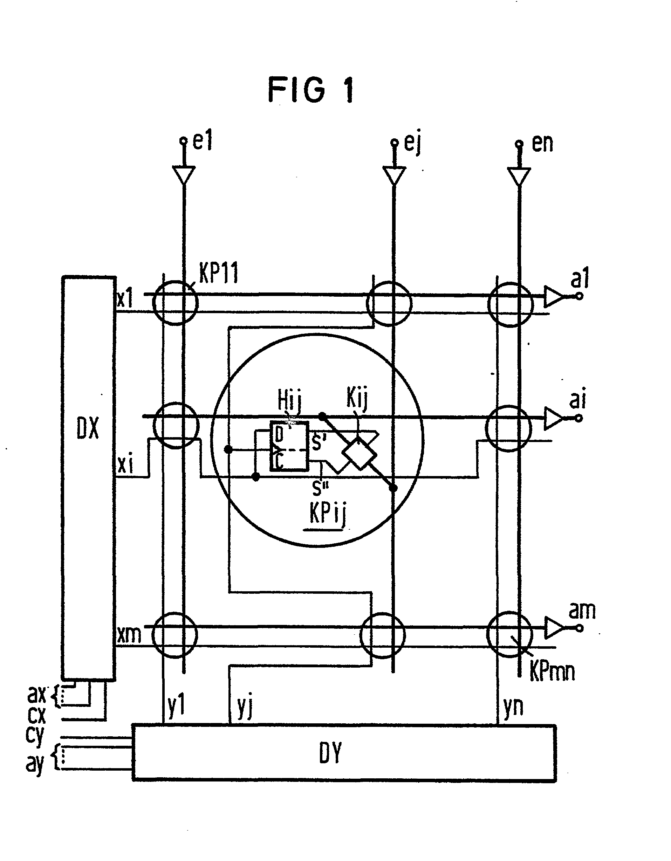

In der Zeichnung FIG 1 ist schematisch in einem zum Verständnis der Erfindung erforderlichen Umfange eine Breitbandsignal-Raumkoppeleinrichtung gemäß der Erfindung skizziert. Diese Raumkoppeleinrichtung weist eine Koppelpunktmatrix mit Koppelpunkten KPII...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert werden; diese Haltespeicherzelle Hij (beim Koppelpunkt KPij) ist durch ein bistabiles D-Kippglied gebildet, dessen beide Ausgänge s'und s" zu entsprechenden Steuereingängen des jeweiligen Koppelelements (Kij beim Koppelpunkt KPij) führen.

Die Halte-Speicherzellen ... Hij... werden ihrerseits durch zwei Ansteuerdecoder, nämlich einen Zeilendecoder DX und einen Spaltendecoder DY, über entsprechende Ansteuerleitungen xl...xi...xm; yl...yj...yn in zwei Koordinaten angesteuert; dabei ist der in Zeilenrichtung ansteuernde Decoder DX mit seinem jeweiligen Decoderausgang ...xi... an die D-Eingänge D der in der betreffenden Matrixzeile , im Beispiel in der i-ten-Zeile, angeordneten D-Kippglieder ...Hij... geführt, während der in Spaltenrichtung ansteuernde Decoder DY mit seinem jeweiligen Decoderausgang ...yj... an die Clock-Eingänge C der in der betreffenden Matrixspalte, beispielsweise in der j-ten Spalte, angeordneten D-Kippglieder ..Hij.. geführt ist.

Wie dies aus FIG 1 ersichtlich ist, mögen die beiden Ansteuerdecoder DX, DY über Eingangsleitungen ax, ay, jeweils mit einer einer Matrixreihe (Zeile bzw. Spalte) von Koppelpunkten gemeinsamen Koppelpunktzeilen- bzw. Koppelpunktspalten-Adresse und über Eingangsleitungen cx, cy jeweils mit einem Adreßtaktsignal beaufschlagbar sein, auf die hin sie jeweils an der der jeweiligen Koppelpunktreihen-Adresse entsprechenden Ansteuerleitung zeitgerecht jeweils ein Ansteuersignal abgeben.

Das Zusammentreffen eines Zeilenansteuersignals und eines Spaltenansteuersignals am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Halte-Speicherzelle Hij, mit der Folge, daß das von der betreffenden Halte-Speicherzelle (Hij) gesteuerte Koppelelement, im Beispiel das Koppelelement Kij, leitend wird.

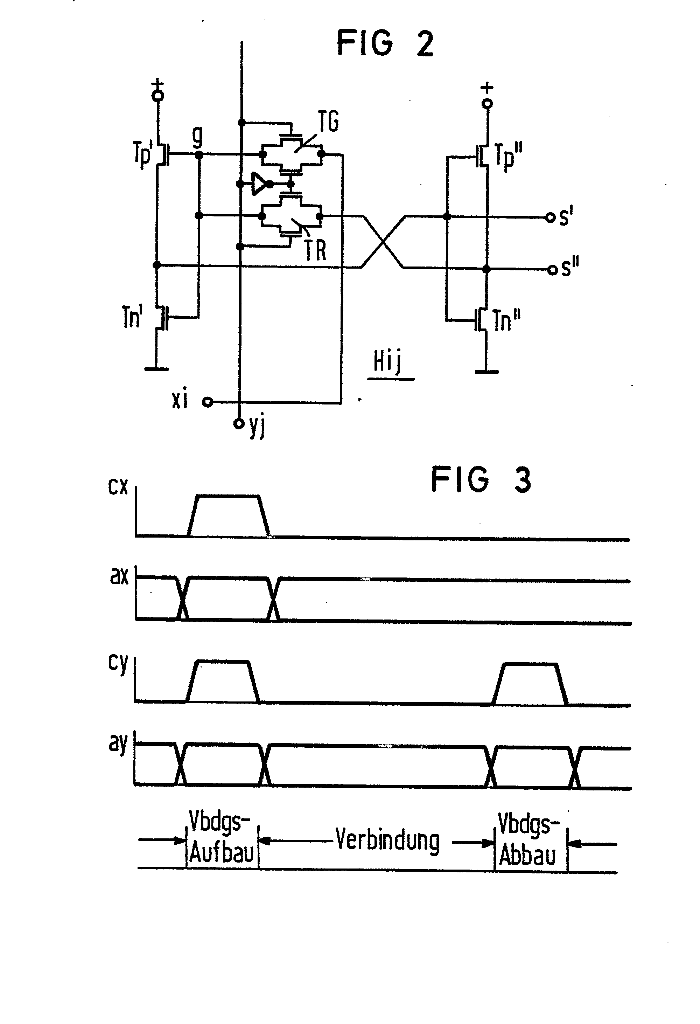

Aus FIG 3 wird dazu deutlich, daß zu einem solchen Zusammentreffen eines Zeilensteuersignals und eines Spaltensteuersignals bei einem Verbindungsaufbau sowohl der Zeilendecoder DX über seine Eingangsleitungen ax (in FIG 1) mit einer Zeilenadresse und über seine Eingangsleitung cx (in FIG 1) mit einem Adreßtaktsignal beaufschlagt wird, wie dies in FIG 3ax und FIG 3cx angedeutet ist, als auch der Spaltendecoder DY über seine Eingangsleitungen ay (in FIG 1) mit einer Spaltenadresse und über seine Eingangsleitung cy (in FIG 1) mit einem Adreßtaktsignal beaufschlagt wird, wie dies in FIG 3ay und FIG 3cy angedeutet ist.

Aus FIG 3 wird weiterhin deutlich, daß bei einem Verbindungs abbau nur der Spaltendecoder DY über seine Eingangsleitungen ay mit einer Spaltenadresse und über seine Eingangsleitung cy mit einem Adreßtaktsignal beaufschlagt wird, wie dies in FIG 3ay und FIG 3cy angedeutet ist:

Damit das im Beispiel betrachtete Koppelelement Kij, bei einem Abbau der betreffenden Verbindung wieder gesperrt wird, genügt nämlich die Abgabe allein eines entsprechenden Spaltenansteuersignals durch den Spaltendecoder DY über dessen Ansteuerleitung yj, ohne daß der Zeilendecoder DX über seine Zeilenansteuerleitung xi ein Ansteuersignal abgibt; das allein am Clock-Eingang C der zum Koppelpunkt Kpij gehörenden Halte-Speicherzelle Hij auftretende Steuersignal bewirkt dann die Rücksetzung der Halte-Speicherzelle Hij mit der Folge, daß das von ihr gesteuerte Koppelelement Kij gesperrt wird.

Die Koppelelemente ..Kij... können dabei beispielsweise jeweils als C-MOS-Transfergate (C-MOS-Transmissiongate) ausgebildet sein, wie dies für Breitbandsignal-Raumkoppeleinrichtungen (z.B. aus ISS'84 Conference Papers 23C1, Fig.9) bekannt ist und hier daher nicht näher erläutert werden muß.

Die Speicherzellen ... Hij.. können, wie dies aus FIG 2 ersichtlich ist, jeweils mit zwei kreuzgekoppelten C-MOS-Inverterschaltungen Tp', Tn'; Tp", Tn" gebildet sein, deren eine mit ihrem Eingang g an den zugehörigen Decoderausgang, beispielsweise den Decoderausgang xi (in FIG1), des einen Ansteuerdecoders (DX in FIG 1) über ein C-MOS-Transfergate TG angeschlossen ist; dieses C-MOS-Transfergate ist an seinem einen Steuereingang mit dem Ausgangssignal des zugehörigen Decoderausgangs, beispielsweise des Decoderausgangs yj (in FIG 1), des anderen Ansteuerdecoders (DY in FIG 1) und an seinem anderen Steuereingang mit dem negierten Ausgangssignal dieses Decoderausgangs (yj) beaufschlagt, und ebenso ist auch ein in den zu dem genannten Eingang g der einen C-MOS-Inverterschaltung Tp', Tn' führenden Rückkopplungsweg eingefügtes weiteres C-MOS-Transfergate TR an seinem einen Steuereingang mit dem Ausgangssignal und an seinem anderen Steuereingang mit dem negierten Ausgangssignal des genannten Decoderausgangs yj beaufschlagt.

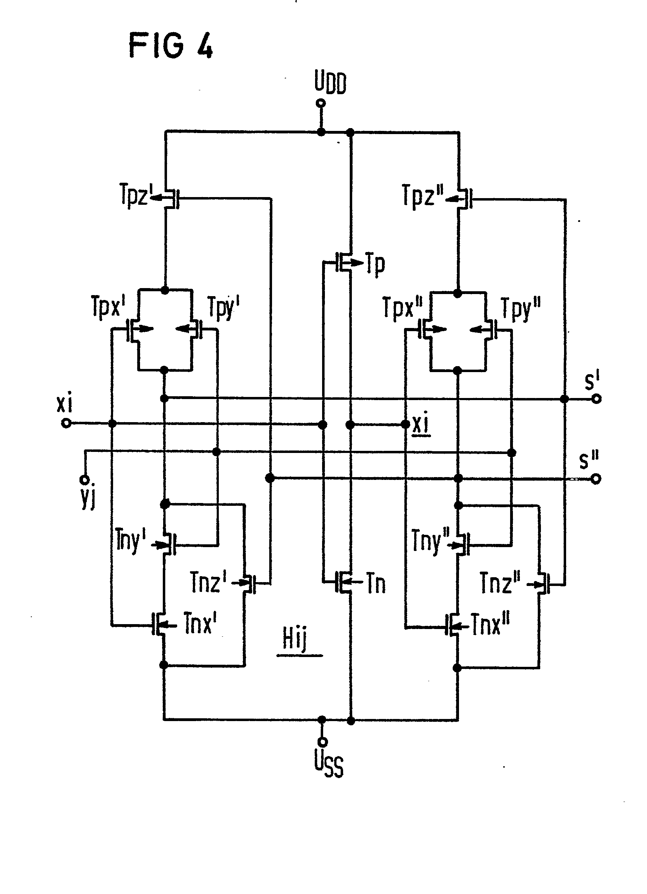

In einer alternativen Ausgestaltung der Erfindung ist es aber auch möglich, die Speicherzellen ... Hij ... in anderer Weise zu realisieren, wie dies beispielsweise aus FIG 4 ersichtlich ist:

Gemäß FIG 4 weist eine Speicherzelle Hij zunächst ein an seinem einen Eingang xi mit dem Ausgangssignal des zugehörigen Decoderausgangs (xi in FIG 1) des einen Ansteuerdecoders (DX in FIG 1) und an seinem anderen Eingang yj mit dem Ausgangssignal des zugehörigen Decoderausgangs (yj in FIG 1) des anderen Ansteuerdecoders (DY in FIG 1) beaufschlagtes erstes C-MOS-NAND-Glied Tpx',Tpy', Tnx',Tny' auf. In Serie zu der in diesem C-MOS-NAND-Glied enthaltenen Parallelschaltung zweier MOS-Transistoren des einen Kanaltyps, im Beispiel in Serie zur Parallelschaltung der beiden p-Kanal-Transistoren Tpx' und Tpy', liegt ein zusätzlicher MOS-Transistor Tpz' gleichen Kanaltyps; parallel zu der im C-MOS-NAND-Glied enthaltenen Serienschaltung zweier MOS-Transistoren des anderen Kanaltyps, im Beispiel parallel zur Serienschaltung der beiden n-Kanal-Transistoren Tnx' und Tny', liegt ein zusätzlicher MOS-Transistor Tnz' gleichen Kanaltyps.

Ausserdem weist die Speicherzelle Hij gemäß FIG 4 ein zweites C-MOS-NAND-Glied Tpx", Tpy", Tnx",Tny" auf, und zwar ebenfalls mit einem in Serie zu dessen Parallelschaltung zweier MOS-Transistoren Tpx",Tpy" des einen Kanaltyps geschalteten zusätzlichen MOS-Transistor Tpz" gleichen Kanaltyps und einem parallel zu seiner Serienschaltung zweier MOS-Transistoren Tnx", Tny" des anderen Kanaltyps geschalteten zusätzlichen MOS-Transistor Tnz" gleichen Kanaltyps. Dieses zweite C-MOS-NAND-Glied Tpx", Tpy", Tnx", Tny" ist an seinem einen Eingang xi mit dem negierten Ausgangssignal des zugehörigen Decoderausgangs (xi in FIG 1) des einen Ansteuerdecoders (DX in FIG 1) und an seinem anderen Eingang yj mit dem Ausgangssignal des zugehörigen Decoderausgangs (yj in FIG 1) des anderen Ansteuerdecoders (DY in FIG 1) beaufschlagt. In FIG 4 ist dazu angedeutet, daß der Eingang xi an den Ausgang eines C-MOS-Inverters Tp, Tn angeschlossen ist, dessen Eingang mit dem Eingang xi des ersten C-MOS-NAND-Gliedes Tpx',Tpy',Tnx',Tny' zusammengeschaltet ist.

Die Steuerelektroden der beiden zusätzlichen MOS-Transistoren Tpx', Tnz' bzw. Tpz", Tnz" jedes C-MOS-NAND-Gliedes sind jeweils mit dem Ausgang s" bzw. s' des jeweils anderen C-MOS-NAND-Gliedes verbunden.

**Patentansprüche**

1. Breitbandsignal-Raumkoppeleinrichtung mit einer Koppelpunktmatrix, deren Koppelelemente (Kij) jeweils mit Hilfe einer in zwei Koordinaten angesteuerten, mit einem bistabilen D-Kippglied gebildeten koppelpunktindividuellen Speicherzelle (Hij) gesteuert werden, dadurch gekennzeichnet, daß die Koppelelemente (Kij) jeweils unmittelbar von den mit bistabilen D-Kippgliedern in C-MOS-Technik gebildeten Speicherzellen (Hij) gesteuert werden, die von zwei jeweils mit einer Koppelpunktreihen-Adresse (ax, ay) und einem Adresstaktsignal (cx, cy) beaufschlagten Ansteuerdecodern (DX, DY) ansteuerbar sind, von denen der in der einen Koordinatenrichtung (Zeilenrichtung) ansteuernde Decoder (DX) mit seinem jeweiligen Decoderausgang (xi) an die D-Eingänge (D) der in der betreffenden Matrixreihe (i) angeordneten D-Kippglieder (Hij) geführt ist und der in der anderen Koordinatenrichtung (Spaltenrichtung) ansteuernde Decoder (DY) mit seinem jeweiligen Decoderausgang (yj) an die Clock-Eingänge (C) der in der betreffenden Matrixreihe (j) angeordneten D-Kippglieder (Hij) geführt ist, wobei die Speicherzellen (Hij) jeweils mit zwei kreuzgekoppelten C-MOS-Inverterschaltungen (Tp′, Tn′; Tp″, Tn″) gebildet sind, deren eine (Tp′, Tn′) mit ihrem Eingang (g) an den zugehörigen Decoderausgang (xi) des einen Ansteuerdecoders über ein C-MOS-Transfergate (TG) angeschlossen ist, das seinerseits - ebenso wie ein in den zu diesem Eingang (g) der einen C-MOS-Inverterschaltung (Tp′, Tn′) führenden Rückkopplungsweg eingefügtes weiteres C-MOS-Transfergate (TR) - an seinem einen Eingang mit dem Ausgangssignal des zugehörigen Decoderausgangs (yj) des anderen Ansteuerdecoders und an seinem anderen Eingang mit dem negierten Ausgangssignal dieses Decoderausgangs (yj) beaufschlagt ist.

2. Breitbandsignal-Raumkoppeleinrichtung mit einer Koppelpunktmatrix, deren Koppelelemente (Kij) jeweils mit Hilfe einer in zwei Koordinaten angesteuerten, mit einem bistabilen D-Kippglied gebildeten koppelpunktindividuellen Speicherzelle (Hij) gesteuert werden, dadurch gekennzeichnet, daß die Koppelelemente (Kij) jeweils unmittelbar von den mit bistabilen D-Kippgliedern in C-MOS-Technik gebildeten Speicherzellen (Hij) gesteuert werden, die von zwei jeweils mit einer Koppelpunktreihen-Adresse (ax, ay) und einem Adresstaktsignal (cx, cy) beaufschlagten Ansteuerdecodern (DX, DY) ansteuerbar sind, von denen der in der einen Koordinatenrichtung (Zeilenrichtung) ansteuernde Decoder (DX) mit seinem jeweiligen Decoderausgang (xi) an die D-Eingänge (D) der in der betreffenden Matrixreihe (i) angeordneten D-Kippglieder (Hij) geführt ist und der in der anderen Koordinatenrichtung (Spaltenrichtung) ansteuernde Decoder (DY) mit seinem jeweiligen Decoderausgang (yj) an die Clock-Eingänge (C) der in der betreffenden Matrixreihe (j) angeordneten D-Kippglieder (Hij) geführt ist, wobei die Speicherzellen (Hij) jeweils

- mit einem an seinem einen Eingang (x) mit dem Ausgangssignal des zugehörigen Decoderausgangs des einen Ansteuerdecoders und an seinem anderen Eingang (y) mit dem Ausgangssignal des zugehörigen Decoderausgangs des anderen Ansteuerdecoders beaufschlagten C-MOS-NAND-Glied (Tpx′, Tpy′, Tnx′, Tny′)

-- mit einem in Serie zu dessen Parallelschaltung zweier MOS-Transistoren (Tpx′, Tpy′) des einen Kanaltyps geschalteten zusätzlichen MOS-Transistor (Tpz′) gleichen Kanaltyps

-- und einem parallel zu seiner Serienschaltung zweier MOS-Transistoren (Tnx′, Tny′) des anderen Kanaltyps geschalteten zusätzlichen MOS-Transistor (Tnz′) gleichen Kanaltyps

- und einem an seinem Eingang (x) mit dem negierten Ausgangssignal des zugehörigen Decoderausgangs des einen Ansteuerdecoders und an seinem anderen Eingang (y) mit dem Ausgangssignal des zugehörigen Decoderausgangs des anderen Ansteuerdecoders beaufschlagten C-MOS-NAND-Glied (Tpx″, Tpy″, Tnx″, Tny″)

-- mit einem in Serie zu dessen Parallelschaltung zweier MOS-Transistoren (Tpx″, Tpy″) des einen Kanalstyps geschalteten zusätzlichen MOS-Transistor (Tpz″) gleichen Kanaltyps

-- und einem parallel zu seiner Serienschaltung zweier MOS-Transistoren (Tnx″, Tny″) des anderen Kanaltyps geschalteten zusätzlichen MOS-Transistor (Tnz″) gleichen Kanaltyps gebildet sind, wobei die Steuerelektroden der beiden zusätzlichen MOS-Transistoren (Tpz′, Tnz′; Tpz″, Tnz″) jedes C-MOS-NAND-Gliedes jeweils mit dem Ausgang (e″; e′) des jeweiligen anderen C-MOS-NAND-Gliedes verbunden sind.

## Claims

1. Space-division switching device for broadband signals having a switching matrix, the switching elements (Kij) of which are controlled in each case with the aid of a crosspoint-specific memory cell (Hij) which is formed by a bistable D-type flip-flop and is addressed with two coordinates, characterized in that the switching elements (Kij) are controlled in each case directly by the memory cells (Hij) formed in C-MOS technology by bistable D-type flip-flops, which memory cells can be addressed by two address decoders (DX, DY) respectively receiving a crosspoint row address (ax, ay) and an address clock signal (cx, cy), of which the decoder (DX) addressing in the one coordinate direction (row direction) is connected with its respective decoder output (xi) to the D inputs (D) of the D-type flip-flops (Hij) arranged in the respective matrix row (i), and the decoder (DY) addressing in the other coordinate direction (column direction) is connected with its respective decoder output (yj) to the clock inputs (C) of the D-type flip-flops (Hij) arranged in the respective matrix row (j), in which arrangement the memory cells (Hij) are in each case formed by two cross-coupled C-MOS inverter circuits (Tp′, Tn′; Tp″, Tn″), one of which (Tp′, Tn′) is connected with its input (g) to the associated decoder output (xi) of the one address decoder via a C-MOS transfer gate (TG), which in turn - just like a further C-MOS transfer gate (TR) inserted into the feedback path leading to this input (g) of the one C-MOS inverter circuit (Tp′, Tn′) - receives at its one input the output signal of the associated decoder output (yj) of the other address decoder and receives at its other input the negated output signal of said decoder output (yj).

2. Space-division switching device for broadband signals having a switching matrix, the switching elements (Kij) of which are controlled in each case with the aid of a crosspoint-specific memory cell (Hij) which is formed by a bistable D-type flip-flop and is addressed with two coordinates, characterized in that the switching elements (Kij) are controlled in each case directly by the memory cells (Hij) formed in C-MOS technology by bistable D-type flip-flops, which memory cells can be addressed by two address decoders (DX, DY) respectively receiving a crosspoint row address (ax, ay) and an address clock signal (cx, cy), of which the decoder (DX) addressing in the one coordinate direction (row direction) is connected with its respective decoder output (xi) to the D inputs (D) of the D-type flip-flops (Hij) arranged in the respective matrix row (i), and the decoder (DY) addressing in the other coordinate direction (column direction) is connected with its respective decoder output (yj) to the clock inputs (C) of the D-type flip-flops (Hij) arranged in the respective matrix row (j), in which arrangement the memory cells (Hij) are in each case formed,

- by a C-MOS-NAND element (Tpx', Tpy', Tnx', Tny') receiving at its one input (x) the output signal of the associated decoder output of the one address decoder and receiving at its other input (y) the output signal of the associated decoder output of the other address decoder

-- with an additional MOS transistor (Tpz') of the same channel the connected in series to the parallel circuit thereof of two MOS transistors (Tpx', Tpy') of the one channel the

-- and an additional MOS transistor (Tnz') of the same channel the connected parallel to the series circuit thereof of two MOS transistors (Tnx', Tny') of the other channel the

- and a C-MOS-NAND element (Tpx", Tpy", Tnx", Tny") receiving at its input (x) the negated output signal of the associated decoder output of the one address decoder and receiving at its other input (y) the output signal of the associated decoder output of the other address decoder

-- with an additional MOS transistor (Tpz") of the same channel type connected in series to the parallel circuit thereof of two MOS transistors (Tpx", Tpy") of the one channel type

-- and an additional MOS transistor (Tnz") of the same channel type connected parallel to the series circuit thereof of two MOS transistors (Tnx", Tny") of the other channel type, in which arrangement the control electrodes of the two additional MOS transistors (Tpz', Tnz'; Tpz", Tnz") of each C-MOS-NAND element are connected in each case to the output (e"; e') of the respective other C-MOS-NAND element.

## Revendications

1. Dispositif de couplage spatial pour signaux à large bande comportant une matrice de points de couplage, dont les éléments de couplage (Kij) sont commandés respectivement à l'aide d'une cellule de mémoire (Hij) commandée suivant deux coordonnées, prévue pour chaque point de couplage et formée par un circuit à bascule bistable de type D, caractérisé par le fait que les éléments de couplage (Kij) sont commandés respectivement directement par des cellules de mémoire (Hij) formées par des circuits à bascule bistable de type D selon la technique C-MOS et pouvant être commandées par deux décodeurs de commande (DX, DY), qui sont chargés respectivement par une adresse (ax, ay) de rangées de points de couplage et par un signal de cadence d'adresse (cx, cy), et parmi lesquels le décodeur (DX), qui réalise la commande dans une direction de coordonnées (direction des lignes), est raccordé par sa sortie respective (xi) aux entrées D (D) des circuits à bascule bistable (Hij) disposés dans la rangée considérée (i) de la matrice, et le décodeur (DY), qui réalise la commande dans l'autre direction de coordonnées (direction des colonnes) est raccordé, par sa sortie respective (yj) aux entrées d'horloge (C) des circuits à bascule de type D (Hij) disposés dans la rangée considérée (j) de la matrice, les cellules de mémoire (Hij) étant formées respectivement par deux circuits inverseurs C-MOS (Tp', Tn'; Tp", Tn"), qui sont raccordés selon un couplage croisé et dont l'un (Tp', Tn') est raccordé par son entrée (g) à la sortie associée (xi) d'un décodeur de commande par l'intermédiaire d'une porte de transfert C-MOS (TG), dont l'une des entrées est chargée pour sa part -de même qu'une autre porte de transfert C-MOS (TR) insérée dans la voie de réaction aboutissant à cette entrée (g) du premier circuit inverseur C-MOS (Tpn', Tn')- par le signal de sortie de la sortie associée (yj) de l'autre décodeur de commande et dont l'autre entrée est chargée par le signal de sortie négativé de cette sortie (yj) du décodeur.

2. Dispositif de couplage spatial pour signaux à large bande comportant une matrice de points de couplage, dont les éléments de couplage (Kij) sont commandés respectivement à l'aide d'une cellule de mémoire (Hij) commandée suivant deux coordonnées, prévue pour chaque point de couplage et formée par un circuit à bascule bistable de type D, caractérisé par le fait que les éléments de couplage (Kij) sont commandés respectivement directement par des cellules de mémoire (Hij) formées par des circuits à bascule bistable de type D selon la technique C-MOS et pouvant être commandées par deux décodeurs de commande (DX, DY), qui sont chargés respectivement par une adresse (ax, ay) de rangées de points de couplage et par un signal de cadence d'adresse (cx, cy), et parmi lesquels le décodeur (DX), qui réalise la commande dans une direction de coordonnées (direction des lignes), est raccordé par sa sortie respective (xi) aux entrées D (D) des circuits à bascule bistable (Hij) disposés dans la rangée considérée (i) de la matrice, et le décodeur (DY), qui réalise la commande dans l'autre direction de coordonnées (direction des colonnes) est raccordé, par sa sortie respective (yj) aux entrées d'horloge (C) des circuits à bascule de type D (Hij) disposés dans la rangée considérée (j) de la matrice, les cellules de mémoire (Hij) étant formées respectivement

- par un circuit NON-ET C-MOS (Tpx', Tpy', Tnx', Tny'), dont une entrée (x) est chargée par le signal de sortie de la sortie associée du premier décodeur de commande et dont l'autre entrée (y) est chargée par le signal de sortie de la sortie associée de l'autre décodeur de commande,

-- avec un transistor MOS supplémentaire (Tpz') branché en série avec le montage en parallèle de ce circuit NON-ET, comprenant deux transistors MOS (Tpx', Tpy') possédant un premier type de canal, et possédant ce même type de canal,

-- et avec un transistor MOS supplémentaire (Tnz') branché en parallèle avec le montage série de ce circuit NON-ET, incluant deux transistors MOS (Tnx', Tny') possédant l'autre type de canal, et possédant ce même type de canal,

- par un circuit NON-ET C-MOS (Tpx", Tpy", Tnx", Tny"), dont une entrée (x) est chargée par le signal de sortie de la sortie associée du premier décodeur de commande et dont l'autre entrée (y) est chargée par le signal de sortie de la sortie associée de l'autre décodeur de commande,

-- avec un transistor MOS supplémentaire (Tpz') branché en série avec le montage en parallèle de ce circuit NON-ET, comprenant deux transistors MOS (Tpx", Tpy") possédant un premier type de canal, et possédant ce même type de canal,

-- et avec un transistor MOS supplémentaire (Tnz') branché en parallèle avec le montage série de ce circuit NON-ET, incluant deux transistors MOS (Tnx", Tny") possédant l'autre type de canal, et possédant ce même type de canal, les électrodes de commande des deux transistors MOS supplémentaires (Tpz', Tnz'; Tpz", Tnz') de chaque circuit NON-ET C-MOS étant reliées respectivement à la sortie (e"; e') de l'autre circuit NON-ET et C-MOS respectif.

# FIG 1

EP 0 217 203 B1

FIG 2

FIG 3

# FIG 4